# EUROPEAN PATENT APPLICATION

(11) **EP 2 955 764 A1**
(43) Date of publication of application: **16.12.2015**
(21) Application number: 14748954.6
(22) Date of filing: 17.01.2014
(51) Int. Cl.: H01L 33/58, H01L 33/50

(54) **LIGHT-EMITTING MODULE**

(30) Priority: 06.02.2013 JP 2013021789
(71) Applicant: Koito Manufacturing Co., Ltd., Tokyo 108-8711 (JP)
(72) Inventor: TSUTSUMI, Yasuaki, Shizuoka-shi Shizuoka 424-8764 (JP)
(74) Representative: Algemeen Octrooi- en Merkenbureau B.V.
(86) International application number: PCT/JP2014/000218
(87) International publication number: WO 2014/122888

(57) **Abstract**

A light emitting module 10 includes: a semiconductor light emitting element 12 that emits light of a first color; a wavelength conversion layer 14 that subjects at least a portion of the light of the first color to wavelength conversion and emits light of a second color; and a diffusing layer 16 that diffuses at least one of the light of the first color and the light of the second color. The diffusing layer 16 includes a matrix 16a and a diffusing member 16b distributed in the matrix. The wavelength conversion layer 14 includes a wavelength conversion substance. A difference between a refractive index of the wavelength conversion layer and a refractive index of the matrix is 0.3 or less, and a difference between a refractive index of the matrix and a refractive index of the diffusing member is 0.05 or more.

## Description

### [TECHNICAL FIELD]

The present invention relates to a light emitting module including a semiconductor light emitting element.

### [BACKGROUND ART]

Fluorescent lights and electric bulbs have been widely used as lamps for illumination. Recently, various white light emitting devices in which light emitting diodes (LED) are used have been developed to replace related-art lamps to meet the need for power consumption and life.

In ordinary white-light LEDs, an LED chip that emits blue light is used. A wavelength conversion layer for receiving blue light as excitation light and converting a portion of the blue light into yellow light is provided. Pseudo white light is produced by mixing the blue light and the yellow light. However, the blue light and the yellow light are emitted from separate places in this configuration so that chromaticity unevenness is likely to result.

Patent document 1 discloses an illumination device including a first resin layer that covers a light emitting element, and a second resin layer that is formed to have a lower viscocity than the first resin layer and is provided on the first resin layer, wherein a diffusing agent or a reflecting agent is included in the first resin layer and a phosphor is included in the second resin layer. According to the disclosure, chromaticity unevenness of white light is reduced by diffusing light emitted by an LED chip in multiple directions by the diffusing agent or the reflecting agent and by promoting production of yellow light by exciting the phosphor.

[patent document 1] JP2007-43074

### [PROBLEM TO BE SOLVED BY THE INVENTION]

A semiconductor light emitting element includes an electrode inside but the portion of the electrode does not emit light. For this reason, luminance unevenness or chromaticity unevenness on the light emitting surface of the light emitting module may not be prevented merely by including a diffusing agent or a reflecting agent in the resin layer as taught in patent document 1.

The present invention addresses the issue and a purpose thereof is to provide a light emitting module capable of emitting bright and evenly distributed and colored light.

### [MEANS TO SOLVE THE PROBLEM]

A light emitting module according to an embodiment of the present invention comprises: a semiconductor light emitting element that emits light of a first color; a wavelength conversion layer that subjects at least a portion of the light of the first color to wavelength conversion and emits light of a second color; and a diffusing layer that diffuses at least one of the light of the first color and the light of the second color. The diffusing layer includes a matrix and a diffusing member distributed in the matrix. The wavelength conversion layer includes a wavelength conversion substance. A difference between a refractive index of the wavelength conversion layer and a refractive index of the matrix is 0.3 or less, and a difference between a refractive index of the matrix and a refractive index of the diffusing member is 0.05 or more.

Since the difference between the refractive index of the wavelength conversion layer and the refractive index of the matrix of the diffusing layer is equal to or less than a predetermined value, reflection (e.g., total reflection) between the wavelength conversion layer and the diffusing layer is reduced. For this reason, the portion of the light emitted by the semiconductor light emitting element that is transmitted through the wavelength conversion layer and the diffusing layer and emitted from the light emitting surface is increased. Further, since the difference between the refractive index of the matrix and the refractive index of the diffusing member is equal to or more than a predetermined value, diffusion of light in the diffusing layer is promoted and luminance unevenness and chromaticity unevenness on the light emitting surface are reduced accordingly.

The light emitting module may further comprise an adhesive layer that adhesively bonds the diffusing layer and the wavelength conversion layer. A thickness of the adhesive layer may be 1.0 [µm] or less. This reduces the impact of the adhesive layer on refraction and reflection of light occurring between the diffusing layer and the wavelength conversion layer.

The semiconductor light emitting element may emit blue light, and, given that a peak wavelength of the blue light is denoted by λp [µm], the thickness t [µm] of the adhesive layer may meet (1/8)λp<t<(3/8)λp. This ensures that the thickness of the adhesive layer is about 1/4 the peak wavelength of the blue light so that the impact from the adhesive layer is reduced more successively.

The wavelength conversion layer is a YAG ceramic plate containing an activating component, and the matrix is formed of a YAG ceramic plate. Thus, the main building material is common to the wavelength conversion layer and the diffusing layer so that so that there should be no substantial difference in the refractive index. Accordingly, reflection at the interface between the wavelength conversion layer and the diffusing layer is further reduced.

The wavelength conversion layer may be provided between the semiconductor light emitting element and the diffusing layer. This arrangement is capable of diffusing both the light of the first color and the light of the second color and so reducing chromaticity unevenness more successfully.

The semiconductor light emitting element may be flip chip bonded to a supporting substrate via a bump, and the semiconductor light emitting element may include: a light emitting layer formed on a transparent substrate; and an electrode electrically connected to the bump and formed to extend through the light emitting layer.

Optional combinations of the aforementioned constituting elements, and implementations of the invention in the form of methods, apparatuses, and systems may also be practiced as additional modes of the present invention.

### [ADVANTAGE OF THE PRESENT INVENTION]

According to the present invention, there is provided a light emitting module capable of emitting bright and evenly distributed and colored light.

### [BRIEF DESCRIPTION OF THE DRAWINGS]

Fig. 1 is a schematic cross-sectional view of a light emitting module according to the first embodiment;
Fig. 2A is a schematic cross-sectional view of the semiconductor light emitting element of Fig. 1, and Fig. 2B is a schematic top view of the semiconductor light emitting element;
Fig. 3 schematically shows how light is refracted in the neighborhood of the diffusing member of the diffusing layer;
Fig. 4 is a table showing the configuration and measurement results of the light emitting module according to comparative examples 1 and 2;
Fig. 5 is a table showing the configuration and measurement results of the light emitting module according to examples 1-6; and
Fig. 6 is a table showing the configuration and measurement results of the light emitting module according to examples 7-11.

### [BEST MODE FOR CARRYING OUT THE INVENTION]

A description will be given of the embodiments of the present invention with reference to the drawings. Like numerals represent like elements so that the description will be omitted accordingly.

### (First embodiment)

### [Light emitting module]

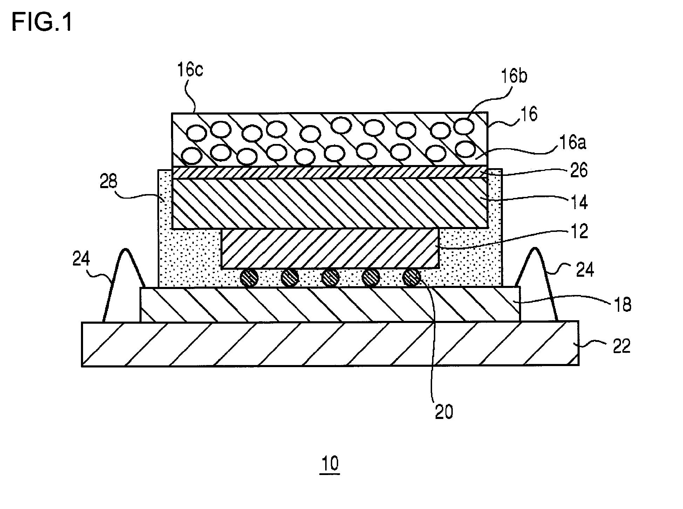

Fig. 1 is a schematic cross sectional view of a light emitting module 10 according to the first embodiment. The light emitting module 10 shown in Fig. 1 includes a semiconductor light emitting element 12 emitting light of the first color, a wavelength conversion layer 14 subjecting at least a portion of the light of the first color (e.g., blue light) emitted by the semiconductor light emitting element to wavelength conversion so as to emit light of the second color (e.g., yellow light) that is different from the light of the first color and that is in a complementary color relationship with the light of the first color, and a diffusing layer 16 diffusing at least one of the light of the first color and the light of the second color. The diffusing layer 16 is provided with a matrix 16a and a diffusing member 16b distributed in the matrix. The wavelength conversion layer 14 includes, for example, a phosphor as a wavelength conversion substance.

The semiconductor light emitting element 12 is flip chip bonded to a device mounting substrate 18 via a bump 20. The device mounting substrate 18 is mounted on a packaging substrate 22. The electrodes of the device mounting substrate 18 and the packaging substrate 22 are electrically connected via a wire 24. The wire 24 is a conducting member made of gold wire or the like. For example, the wire 24 is bonded to an electrode on top of the device mounting substrate 18 and an electrode on top of the packaging substrate 22 by, for example, ultrasonic thermal compression and electrically connects the electrodes.

The light emitting module 10 according to the embodiment is further provided with an adhesive layer 26 adhesively bonding the diffusing layer 16 and the wavelength conversion layer 14. The adhesive layer 26 may not be provided if the diffusing layer 16 and the wavelength conversion layer 14 can be bonded directly.

A light emitting diode or a laser diode capable of emitting blue light may be used as the semiconductor light emitting element 12. A specific example may be an InGaN-based compound semiconductor. The light emission wavelength range of an InGaN-based compound semiconductor varies depending on the content of In. The higher the content of In, the longer the light emission wavelength, and the lower the content of In, the shorter the wavelength. It has been verified that the quantum efficiency in light emission is highest in the case of an InGaN-based compound semiconductor in which In is contained in an amount that places the peak wavelength in the vicinity of 400 nm.

Preferably, the wavelength conversion layer 14 is composed of luminescent ceramics or phosphorescent ceramic. For example, the wavelength conversion layer 14 may be produced by sintering a ceramic base created by using the yttrium aluminum garnet powder, which is a phosphor excited by blue light. The wavelength conversion layer 14 according to the embodiment is a YAG ceramic plate containing an activating component. The method of manufacturing light wavelength conversion ceramic is publicly known so that a description thereof is omitted. Unlike, for example, a powder-based phosphor, the wavelength conversion layer 14 thus obtained is capable of restraining light diffusion that would occur on the powder surface and induces very little loss of light emitted by the semiconductor light emitting element 12.

The wavelength conversion layer 14 according to the embodiment converts the wavelength of blue light mainly emitted by the semiconductor light emitting element 12 and emits yellow light. Therefore, the blue light directly transmitted through the wavelength conversion layer 14 and the yellow light subjected to wavelength conversion by the wavelength conversion layer 14 are synthesized and emitted from the light emitting module 10. In this case, the light emitting module 10 is capable of emitting white light.

The wavelength conversion layer 14 is configured as a transparent layer. The term "transparent" in this embodiment means that the total light transmittance in the conversion light wavelength range is 40% or higher. Through our intensive research, we have discovered that the wavelength of light can be converted by the wavelength conversion layer 14 properly and a decrease in the intensity of light transmitted through the wavelength conversion layer 14 is properly restrained, given a transparency in which the total light transmittance in the conversion light wavelength range is 40% or higher. Therefore, the light emitted by the semiconductor light emitting element 12 is efficiently converted by ensuring transparency as defined above in the wavelength conversion layer 14.

It is preferable that the device mounting substrate 18 be formed of a material that is not electrically conductive but has a high thermal conductivity. For example, a ceramic substrate (aluminum nitride substrate, alumina substrate, mullite substrate, glass ceramic substrate) or a glass epoxy substrate may be used. In case an insulating layer is formed underneath the electrode bonded to the bump 20, a metal substrate (preferably, a substance having a high thermal conductivity such as aluminum, copper, brass, etc.), SiC substrate, carbon substrate, a composite metal and carbon substrate, etc. may be used.

The light emitting module 10 is further provided with a white resin 28 so as to cover the under surface and side surface of the semiconductor light emitting element 12 and the wavelength conversion layer 14. The white resin 28 functions as a reflecting member that reflects the light emitted from the bottom or side of the semiconductor light emitting element 12 or the light emitted from the bottom or side of the wavelength conversion layer 14. This increases the light emitted from the light emitting surface of the light emitting module 10 (a light emitting surface 16c of the diffusing layer 16 in Fig. 1) and increases the luminance of the light emitting module.

Fig. 1 shows only one semiconductor light emitting element 12. Alternatively, a plurality of semiconductor light emitting elements 12 may be arranged on the device mounting substrate 18 such that the number of elements and arrangement is determined by the usage of the light emitting module. For example, the semiconductor light emitting elements 12 may be arranged in a grid, on a zigzag line, or linearly on the device mounting substrate 18.

### [Semiconductor light emitting element]

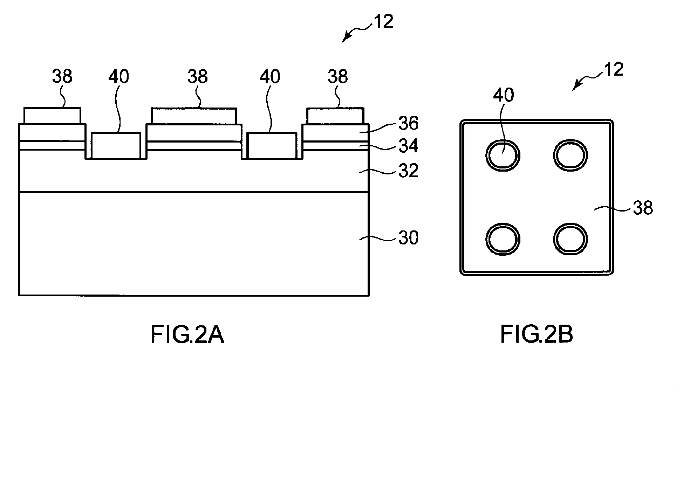

A description will now be given of the structure of the semiconductor light emitting element. Fig. 2A is a schematic cross-sectional view of the semiconductor light emitting element 12 of Fig. 1, and Fig. 2B is a schematic top view of the semiconductor light emitting element 12. A semiconductor layer 32 of the first conductivity type, a light emitting layer 34, and a semiconductor layer 36 of the second conductivity type are laminated in the stated order on a transparent substrate 30. A first electrode 40 is formed on the surface of the semiconductor layer 32 of the first conductivity type exposed as a result of etching in part the semiconductor layer 36 of the second conductivity type, the light emitting layer 34, and the semiconductor layer 32 of the first conductivity type. A second electrode 38 is formed on the semiconductor layer 36 of the second conductivity type. Thus, the semiconductor light emitting element 12 includes the light emitting layer 34 formed on the transparent substrate 30 and the first electrode 40 electrically connected to the bump and formed to extend through the light emitting layer 34.

As can be seen in Figs. 2A and 2B, the light emitting layer 34 is etched in the portion of the first electrode 40 so that light is not produced therefrom when an electric current is fed between the electrodes. For this reason, the portion of the first electrode appears darker than the portions around when the semiconductor light emitting element 12 is observed from above, with the result that luminance unevenness is created. Further, the amount of light incident on the wavelength conversion layer located above the light emitting element is smaller above the first electrode than elsewhere so that blue light is generated in a small amount and chromaticity unevenness is created.

To address this, the diffusing layer 16 according to the embodiment is provided with a matrix 16a formed of a YAG ceramic plate and a diffusing member 16b distributed in the matrix. The diffusing member 16b is implemented by hollow air bubbles or a relatively transparent substance distributed in the matrix. The transparent substance has a refractive index different from that of the YAG ceramic forming the matrix 16a.

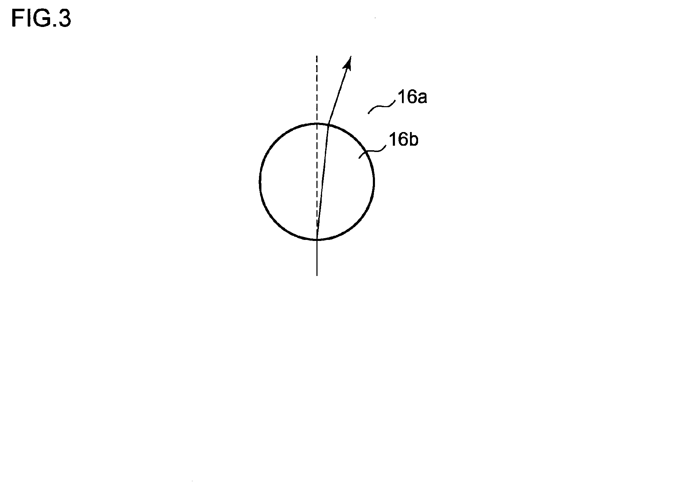

When the light emitted by the semiconductor light emitting element 12 or the wavelength conversion layer 14 is incident on the diffusing layer 16 configured as described above, the light is refracted or reflected at the interface between the matrix 16a and the diffusing member 16b so that the light is diffused in the diffusing layer 16. As a result, luminance unevenness and chromaticity unevenness on the light emitting surface of the light emitting module 10 are reduced. Fig. 3 schematically shows how light is refracted in the neighborhood of the diffusing member 16b of the diffusing layer.

Based on the knowledge described above, it should be noted that the light emitting module 10 according to the embodiment is configured such that the difference between the refractive index of the wavelength conversion layer 14 and the refractive index of the matrix 16a of the diffusing layer 16 is equal to or less than a predetermined value, and the difference between the refractive index of the matrix 16a and the refractive index of the diffusing member 16b is equal to or more than a predetermined value.

Since the difference between the refractive index of the wavelength conversion layer 14 and the refractive index of the matrix 16a of the diffusing layer 16 is equal to or less than a predetermined value, reflection (e.g., total reflection) between the wavelength conversion layer 14 and the diffusing layer 16 is reduced. For this reason, the portion of the light emitted by the semiconductor light emitting element 12 that is transmitted through the wavelength conversion layer 14 and the diffusing layer 16 and emitted from the light emitting surface 16c is increased. The difference between the refractive index of the wavelength conversion layer 14 and the refractive index of the matrix 16a of the diffusing layer 16 is, for example, 0.4 or less, and, preferably, 0.3 or less, and, more preferably, 0.2 or 0.1 or less.

The wavelength conversion layer 14 and the matrix 16a of the diffusing layer 16 according to the embodiment differ in respect of whether or not an activating component is contained. However, the main material forming both is a YAG ceramic plate so that there should be no substantial difference in the refractive index. Accordingly, reflection at the interface between the wavelength conversion layer 14 and the diffusing layer 16 is further reduced.

Further, since the difference between the refractive index of the matrix 16a and the refractive index of the diffusing member 16b is equal to or more than a predetermined value, diffusion of light in the diffusing layer 16 is promoted and luminance unevenness and chromaticity unevenness on the light emitting surface 16c are reduced accordingly. The difference between the refractive index of the matrix 16a and the refractive index of the diffusing member 16b is, for example, 0.05 or more, and, preferably, 0.10 or more, and, more preferably, 0.5 or more.

### (Second embodiment)

The diffusing layer 16 according to the first embodiment is disposed on the emission side of the wavelength conversion layer 14. In the light emitting module according to the second embodiment, the diffusing layer 16 is disposed on the incidence surface of the wavelength conversion layer 14. The adhesive layer 26 is provided between the incidence surface of the wavelength conversion layer 14 and the diffusing layer 16 as needed.

### [Examples]

The examples of the light emitting module according to the embodiments described above will be explained below along with comparative examples.

The light emitting module 10 is assembled and built into a die-cast aluminum heat sink. Thereafter, a 700 mA electric current is fed to the light emitting module 10 and 15 minutes are allowed to pass for stabilization. The luminance [cd], luminance unevenness [cd/mm²], and chromaticity unevenness on the top surface (light emitting surface) of the light emitting module 10 are measured by a 2D chroma meter from Konica Minolta. Luminance unevenness represents a difference between the maximum luminance and the minimum luminance on the light emitting surface of the light emitting module, and chromaticity unevenness represents a difference between the maximum value and the minimum value of the chromaticity Cx on the light emitting surface of the light emitting module.

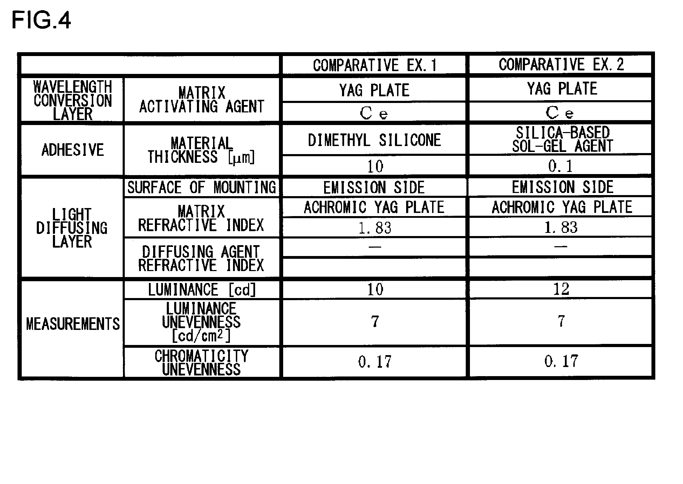

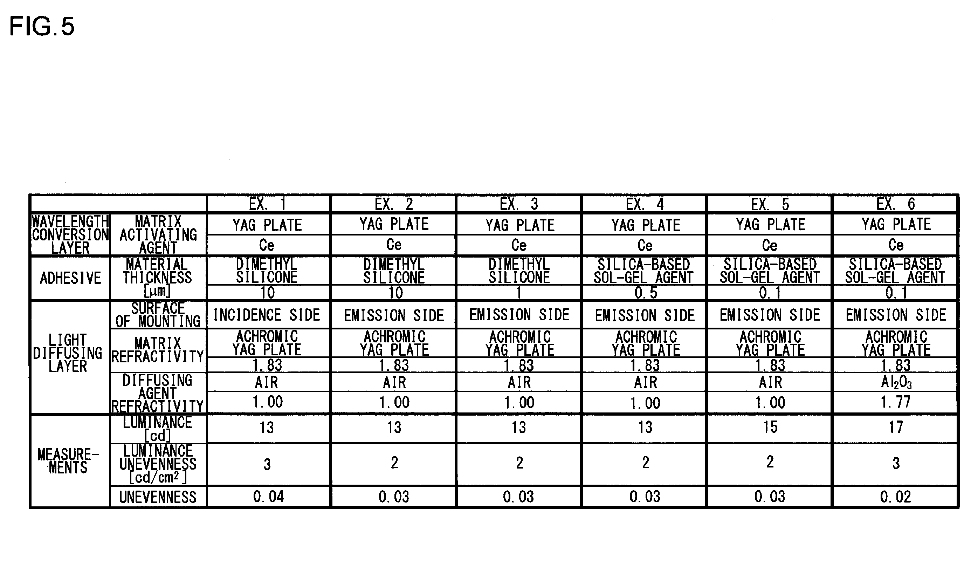

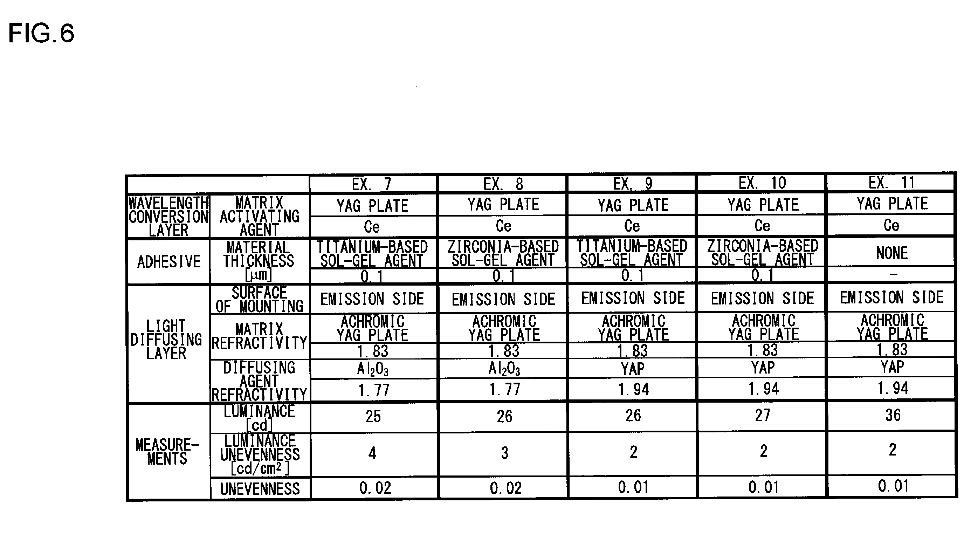

Fig. 4 is a table showing the configuration and measurement results of the light emitting module according to comparative examples 1 and 2. Fig. 5 is a table showing the configuration and measurement results of the light emitting module according to examples 1-6. Fig. 6 is a table showing the configuration and measurement results of the light emitting module according to examples 7-11.

In the case that the light emitting module is built in an automotive lamp to irradiate the road surface, it is preferable that luminance unevenness is 5 cd/mm² or lower. A larger luminance unevenness creates stripes in the light distributed on the road and increase the fatigue of a driver driving a long distance at night. It is also known that chromaticity unevenness of 0.1 or higher results in increased fatigue of a driver driving a long distance at night.

In the case of ordinary light emitting modules, the higher the luminance, the smaller a lighting device can be designed. This is because a smaller size increases the flexibility in design and allows manufacturing an attractive lighting device.

In the light emitting modules according to the comparative examples and the examples, a YAG ceramic plate to which Ce is added as an activating agent is used for the wavelength conversion layer. The light emitting modules according to comparative examples 1 and 2 are built to include a layer implemented by an achromatic YAG ceramic plate corresponding to the light diffusing layer of the examples, but do not include a diffusing member. For this reason, the light modules of comparative examples 1 and 2 are characterized by large values of luminance unevenness and chromaticity unevenness and so are identified as not being suitable for use in an automotive lamp.

Meanwhile, the light diffusing layer of the light emitting modules according to examples 1-11 includes a diffusing member and the difference between the refractive index of the matrix and the refractive index of the diffusing member is 0.05 or more. For this reason, the luminance is improved and luminance unevenness and chromaticity unevenness are significantly reduced in the structure according to any of examples 1 through 11, as compared to the comparative examples. More specifically, the light emitting modules according to the examples 1-11 built in an automotive lamp can reduce the fatigue of a driver driving a long distance at night because luminance unevenness is 5 cd/mm² or lower and chromaticity unevenness is 0.1 or lower.

Comparison of the measurement results of the light emitting modules according to example 1 and example 2 reveals that luminance unevenness and chromaticity unevenness are reduced more successfully in the case that the diffusing layer 16 is disposed on the emission side of the wavelength conversion layer 14 than in the case that the diffusing layer 16 is disposed on the incidence surface of the wavelength conversion layer 14. In other words, the wavelength conversion layer 14 is preferably disposed between the semiconductor light emitting element 12 and the diffusing layer 16. This arrangement diffuses both the blue light emitted by the semiconductor light emitting element 12 and the yellow light emitted by the wavelength conversion layer 14 and so is considered to reduce chromaticity unevenness relatively more successfully.

It is assumed that the thickness of the adhesive layer 26 according to the examples is about 0.1-10 µm. Preferably, however, the thickness is 1.0 [µm] or less. This reduces the impact of the adhesive layer on refraction and reflection of light occurring between the diffusing layer and the wavelength conversion layer.

In particular, significant improvement in the luminance, luminance unevenness, chromaticity unevenness is observed in the light emitting modules according to examples 5-10 in which the thickness of the adhesive layer is less than 0.5 µm, and, more specifically, 0.1 µm.

In other words, given that the peak wavelength λp of the blue light emitted by the semiconductor light emitting element 12 is 0.4 [µm](=400 [nm]), the thickness t [µm] of the adhesive layer of the light emitting modules according to examples 5-10 meets (1/8)λp<t<(3/8)λp. Thus, the impact from the adhesive layer is reduced more successively if the thickness of the adhesive layer is about 1/4 the peak wavelength of the blue light.

It should also be noted that the luminance is particularly high and luminance unevenness and chromaticity unevenness are particularly small in examples 1-9 in which YAP (YAlO₃) characterized by a higher refractive index than the matrix is used as a diffusing member.

The embodiments of the present invention are not limited to those described above and appropriate combinations or replacements of the features of the embodiments are also encompassed by the present invention. The embodiments may be modified by way of combinations, rearranging of the processing sequence, design changes, etc., based on the knowledge of a skilled person, and such modifications are also within the scope of the present invention.

According to the embodiments described above, the semiconductor light emitting element emits blue light, the wavelength conversion layer converts the blue light into yellow light, and white light is produced by mixing the blue light and the yellow light. White light may be produced by alternative methods. For example, the semiconductor light emitting element may emit ultraviolet light, two types of phosphors in the wavelength conversion layer may respectively convert the ultraviolet light into blue light and yellow light, and white light may be produced by mixing the blue light and yellow light.

### [DESCRIPTION OF THE REFERENCE NUMERALS]

10 light emitting module, 12 semiconductor light emitting element, 14 wavelength conversion layer, 16 diffusing layer, 16a matrix, 16b diffusing member, 16c light emitting surface, 18 device mounting substrate, 20 bump, 22 packaging substrate, 24 wire, 26 diffusing layer, 28 white resin, 30 substrate, 34 light emitting layer, 40 first electrode

### [INDUSTRIAL APPLICABILITY]

The present invention is applicable in light emitting modules provided with a semiconductor light emitting element.

## Claims

1. A light emitting module comprising:
a semiconductor light emitting element that emits light of a first color;
a wavelength conversion layer that subjects at least a portion of the light of the first color to wavelength conversion and emits light of a second color; and
a diffusing layer that diffuses at least one of the light of the first color and the light of the second color, wherein
the diffusing layer includes a matrix and a diffusing member distributed in the matrix,
the wavelength conversion layer includes a wavelength conversion substance,
a difference between a refractive index of the wavelength conversion layer and a refractive index of the matrix is 0.3 or less, and
a difference between a refractive index of the matrix and a refractive index of the diffusing member is 0.05 or more.

2. The light emitting module according to claim 1, further comprising:
an adhesive layer that adhesively bonds the diffusing layer and the wavelength conversion layer, and
a thickness of the adhesive layer is 1.0 [µm] or less.

3. The light emitting module according to claim 2, wherein
the semiconductor light emitting element emits blue light, and
given that a peak wavelength of the blue light is denoted by λp [µm], the thickness t [µm] of the adhesive layer meets (1/8)λp<t<(3/8)λp.

4. The light emitting module according to one of claims 1 through 3, wherein
the wavelength conversion layer is a YAG ceramic plate containing an activating component, and
the matrix is formed of a YAG ceramic plate.

5. The light emitting module according to one of claims 1 through 4, wherein
the wavelength conversion layer is provided between the semiconductor light emitting element and the diffusing layer.

6. The light emitting module according to one of claims 1 through 5, wherein
the semiconductor light emitting element is flip chip bonded to a supporting substrate via a bump, and
the semiconductor light emitting element includes:
a light emitting layer formed on a transparent substrate; and
an electrode electrically connected to the bump and formed to extend through the light emitting layer.
